# FASCICULE DE BREVET EUROPEEN

(11) **EP 2 529 416 B1**
(45) Date de publication et mention de la délivrance du brevet: **21.10.2015**
(21) Numéro de dépôt: 11708521.7
(22) Date de dépôt: 26.01.2011
(51) Int. Cl.: H01L 31/0747

(54) **CELLULE PHOTOVOLTAÏQUE COMPRENANT UN FILM MINCE DE PASSIVATION EN OXYDE CRISTALLIN DE SILICIUM ET PROCÉDÉ DE RÉALISATION**
PHOTOVOLTAISCHE ZELLE EINSCHLIESSLICH EINER PASSIVIERUNGSSCHICHT AUS KRISTALLINEM SILICIUMOXID SOWIE VERFAHREN ZU DEREN HERSTELLUNG
PHOTOVOLTAIC CELL, INCLUDING A CRYSTALLINE SILICON OXIDE PASSIVATION THIN FILM, AND METHOD FOR PRODUCING SAME

(30) Priorité: 27.01.2010 FR 1000309
(43) Date de publication de la demande: 05.12.2012
(73) Titulaire: Commissariat à l'Énergie Atomique et aux Énergies Alternatives, 75015 Paris (FR)
(72) Inventeur: MUR, Pierre, F-38920 Crolles (FR); MORICEAU, Hubert, F-38120 Saint-Egrève (FR); RIBEYRON, Pierre-Jean, F-38330 Saint Ismier (FR)
(74) Mandataire: Talbot, Alexandre
(86) Numéro de dépôt international: PCT/FR2011/000050
(87) Numéro de publication internationale: WO 2011/092402

(56) Documents cités:
- WO-A2-2009/094578
- US-A- 5 693 578
- US-A1- 2007 256 728
- US-A1- 2008 083 830
- HURAN, J., GULDAN, A.: "Silicon oxide films prepared by plasma oxidation of silicon and their application for tunnel MIS diodes", ACTA PHYS. SLOV., vol. 39, no. 2, 1 janvier 1990 (1990-01-01), pages 108-115, XP002611749,

## Description

### Domaine technique de l'invention

L'invention concerne une cellule photovoltaïque à hétérojonction comprenant un substrat en silicium cristallin présentant un type de dopage donné et une couche en silicium amorphe ou micro-cristallin, ainsi qu'un procédé de réalisation d'au moins une telle cellule photovoltaïque.

### État de la technique

Une cellule photovoltaïque à hétérojonction est formée d'un empilement multicouche permettant de convertir directement les photons reçus en un signal électrique. L'hétérojonction est, en particulier, formée par un substrat en silicium cristallin d'un type de dopage (n ou p) donné et par une couche en silicium amorphe d'un type de dopage contraire ou opposé à celui du substrat.

De plus, une couche intermédiaire dite de « passivation électrique » est, le plus souvent, disposée entre les deux éléments formant l'hétérojonction, afin d'améliorer les caractéristiques d'interface de l'hétérojonction et donc l'efficacité de la conversion. Comme indiqué dans la demande de brevet US2001/0029978, cette couche intermédiaire est en général une couche en silicium amorphe intrinsèque.

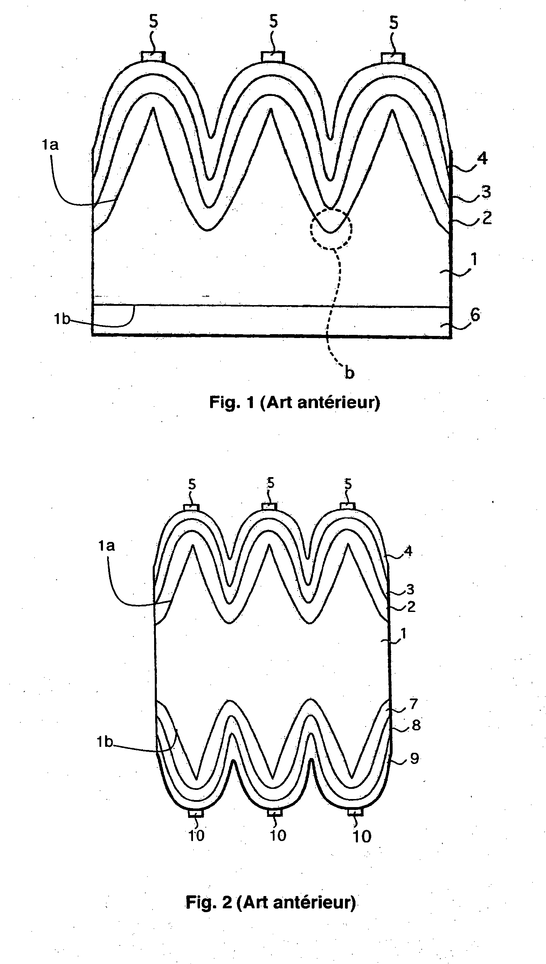

À titre d'exemple, la figure 1 illustre un mode particulier de réalisation d'une cellule photovoltaïque selon l'art antérieur, telle que décrite dans la demande de brevet US2001/0029978. La cellule photovoltaïque à hétérojonction comporte un substrat en silicium cristallin 1, par exemple dopé de type n et comprenant une face avant 1a, recouverte uniformément et successivement par:
- une couche en silicium amorphe intrinsèque 2,
- une couche en silicium amorphe 3, dopé par exemple de type p pour former l'hétérojonction avec le substrat 1,
- une électrode 4, par exemple en oxyde d'indium et d'étain (ou ITO)
- et un collecteur de courant 5 sous la forme d'un peigne.

La face avant 1a du substrat 1 est, de plus, texturée (ou structurée), afin d'augmenter le confinement optique de la cellule.

La face arrière 1b du substrat 1 est, sur la figure 1, plane et recouverte d'une électrode 6. Elle peut, cependant, dans d'autres cas, être texturée et recouverte d'un empilement multicouche comme représenté sur la figure 2. Ainsi, dans ce mode de réalisation, la face arrière 1 b du substrat 1 est recouverte uniformément et successivement par:
- une couche en silicium amorphe intrinsèque 7,
- une couche en silicium amorphe 8, très fortement dopée, par exemple, de type n,
- une électrode 9, en ITO par exemple
- et un collecteur de courant 10 sous la forme d'un peigne.

Ainsi, comme illustré sur les figures 1 et 2, les cellules photovoltaïques à hétérojonction nécessitent de déposer, de manière uniforme, une pluralité de couches très fines (de l'ordre de quelques nanomètres à quelques dizaines de nanomètres) sur un substrat dont au moins une face peut être avantageusement texturée. Par dépôt uniforme d'une couche mince, également appelé dépôt conforme d'une couche mince par certains, on entend le dépôt d'une couche mince d'une épaisseur sensiblement constante afin de suivre le relief de la face sur laquelle la couche mince est déposée.

Or, l'étape de texturation du substrat d'au moins une face, presque toujours nécessaire, ne facilite pas la bonne répartition uniforme de ces couches. En particulier, l'étape de texturation induit une augmentation importante de la surface développée. De plus, dans le domaine des cellules photovoltaïques, il est courant de texturer au moins une face du substrat sous la forme de pyramides. Or, les flancs des pyramides obtenues sont souvent très rugueux et les pointes et creux des pyramides sont abruptes (rayon de courbure en général inférieur à 30 nm), ce qui est néfaste pour obtenir une parfaite uniformité d'épaisseur pour les couches successivement déposées sur la face texturée À titre d'exemple, la demande de brevet US2001/0029978 propose de réaliser une gravure isotropique humide, en utilisant une solution d'acide fluorhydrique (HF) et d'acide nitrique, afin d'arrondir les zones « b » disposées entre deux pyramides. Cependant, cette gravure est trop importante, de l'ordre de 2 µm ou plus, et elle ne permet pas de lisser les flancs des pyramides au niveau nanométrique.

Par ailleurs, l'étape de texturation, ainsi que des étapes de nettoyage, les étapes de gravure et les temps d'attente avant les dépôts peuvent engendrer une contamination de surface (particulaire et/ou métallique) de la face texturée du substrat, ce qui provoque une augmentation importante de la densité d'état de la surface du substrat texturé. Ainsi, ces problèmes de pollution empêchent d'obtenir une bonne passivation de la surface et donc des rendements élevés et ce, malgré l'emploi d'une couche intermédiaire de silicium amorphe intrinsèque comme couche de passivation.

Dans l'article « Optimization of Amorphous Silicon Oxide Buffer Layer for High-Efficiency p-Type Hydrogenated Microcrystalline Silicon Oxide/n-type Cristalline Silicon Heterojonction Solar Cell » de J. Sritharathiikhun et al. (Japanese Journal of Applied Physics, Vol 47, N°11, 2008, pp8452-8455), il est proposé d'utiliser une couche de passivation de surface, en oxyde de silicium amorphe intrinsèque (i-a-SiO:H) entre un substrat en silicium cristallin dopé n (n-a-Si :H) et une couche en oxyde de silicium microcristalline dopée p (p-µc-SiO :H). Une telle couche de passivation est déposée par une technique de dépôt chimique en phase vapeur assisté par plasma à très haute fréquence (VHF-PECVD). De plus, l'épaisseur optimale d'une telle couche est de 6nm. Cependant, la réalisation d'une telle couche de passivation provoque la formation de nombreux défauts au niveau de l'interface entre le substrat en silicium cristallin dopé n et ladite couche de passivation.

Dans WO 2009/094578 une couche d'oxide de silicium amorphe est utilisée comme passivation.

### Objet de l'invention

L'invention a pour but de proposer une cellule photovoltaïque à hétérojonction présentant une bonne passivation de surface, tout en étant facile à mettre en oeuvre.

Selon l'invention, ce but est atteint par le fait qu'une cellule photovoltaïque à hétérojonction comprenant un substrat en silicium cristallin présentant un type de dopage donné et une couche en silicium amorphe ou microcristallin est caractérisée en ce qu'elle comporte au moins un film mince en oxyde cristallin de silicium, disposé directement sur une face du substrat, entre ledit substrat et ladite couche en silicium amorphe ou micro-cristallin.

Selon un développement de l'invention, le film mince en oxyde cristallin de silicium est constitué par une partie superficielle du substrat obtenue par oxydation radicalaire.

Selon un autre développement, le film mince en oxyde cristallin de silicium a une épaisseur inférieure ou égale à 2 nanomètres.

Selon l'invention, ce but est également atteint par le fait que le film mince en oxyde cristallin de silicium est réalisé, avant la formation de la couche en silicium amorphe ou micro-cristallin, par oxydation superficielle radicalaire d'une surface du substrat.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, schématiquement et en coupe, un mode de réalisation particulier d'une cellule photovoltaïque selon l'art antérieur.
- la figure 2 représente, schématiquement et en coupe, une variante de réalisation de la cellule photovoltaïque selon la figure 1.
- les figures 3 à 9 illustrent différents modes de réalisation de cellules photovoltaïques selon l'invention.

### Description de modes particuliers de réalisation

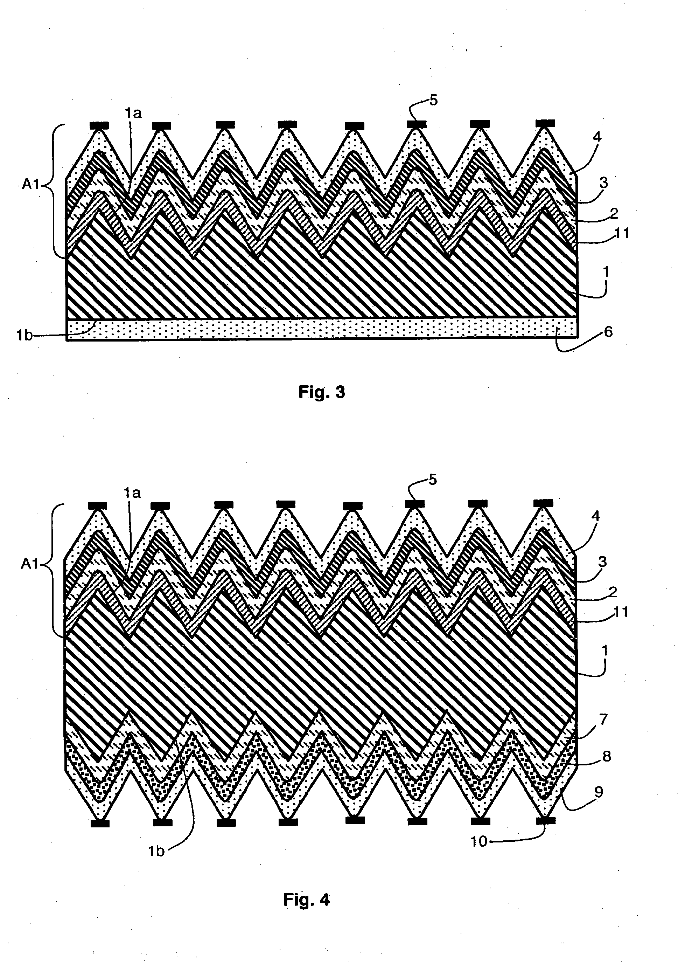

La cellule photovoltaïque selon la figure 3 présente un empilement multicouche sensiblement similaire à celui de la cellule photovoltaïque représentée sur la figure 1. Cependant, sur la figure 3, un film mince 11 en oxyde cristallin de silicium est disposé entre le substrat en silicium cristallin 1 et la couche mince en silicium amorphe intrinsèque 2.

L'ensemble formé par le film mince 11, la couche en silicium amorphe intrinsèque 2, la couche en silicium amorphe 3 dopé p, l'électrode 4 et le collecteur de courant 5 constitue, alors, un empilement multicouche disposé sur la face avant 1a du substrat 1 et noté A1 sur la figure 3.

Plus particulièrement, le film mince 11 est disposé directement sur la face avant 1 a du substrat 1 en silicium cristallin dopé n, entre ledit substrat 1 et la couche en silicium amorphe intrinsèque 2. Par conséquent, il est directement en contact avec la face avant 1 a du substrat 1. De plus, il présente, avantageusement, une épaisseur inférieure ou égale à 2 nanomètres et encore avantageusement comprise entre 0,1nm et 2nm et typiquement de l'ordre de 0,5 nm.

Le film mince 11 est, plus particulièrement, un film mince obtenu en oxydant le silicium d'une partie superficielle du substrat 1, avant la formation des couches minces successives 2, 3, 4 et 5 de l'empilement A1. Par partie superficielle du substrat 1, on entend une zone du substrat 1, s'étendant depuis une surface libre du substrat 1 vers l'intérieur de celui-ci, sur une très faible épaisseur (avantageusement inférieure à 2nm). De plus, le film mince 11 est en oxyde cristallin de silicium, c'est-à-dire un oxyde sous forme cristalline. En particulier, il est supposé que la forme cristalline de l'oxyde de silicium puisse être, dans certains cas, la forme tridymite pour un substrat en silicium ayant un plan cristallographique (100).

De plus, l'oxydation est une oxydation superficielle radicalaire, c'est-à-dire une oxydation réalisée au moyen de radicaux (ou radicaux libres). De tels radicaux sont en particulier des radicaux oxygénés, par exemple obtenus à partir d'oxygène, d'ozone et/ou d'eau.

Les radicaux ainsi obtenus oxydent, alors, le silicium sur une partie superficielle du substrat 1. De plus, l'oxyde de silicium ainsi obtenu pendant l'oxydation radicalaire est au moins en partie sous une forme cristalline. Plus particulièrement, l'oxydation superficielle radicalaire du substrat en silicium est, avantageusement, contrôlée de manière à former ledit film mince cristallin sur la surface du substrat en silicium. L'oxydation superficielle radicalaire du substrat peut cependant, dans certains cas, entraîner la formation supplémentaire, sur l'oxyde cristallin de silicium, d'oxyde de silicium sous une forme amorphe. Cependant l'oxyde cristallin de silicium formant le film mince 11 reste interposé entre le substrat 11 et l'oxyde amorphe de silicium. De plus, l'oxyde de silicium amorphe, avantageusement formé pendant l'oxydation superficielle radicalaire peut, éventuellement, être retiré par décapage, lors d'une étape intermédiaire suivant l'oxydation superficielle radicalaire et, plus particulièrement, avant la formation des autres couches de l'empilement A1.

L'oxydation est, avantageusement, assistée à l'aide d'un plasma ou bien par application de rayonnements ultraviolets sur la surface du substrat à oxyder. Le traitement par plasma ou par rayonnements ultraviolets facilite, en particulier, la formation des radicaux libres utilisés pour oxyder le silicium du substrat 1. Ils sont, plus particulièrement, des radicaux de type O˙, O₂˙ et/ou OH˙, selon le type de traitement et sont en particulier obtenus à partir d'oxygène et/ou d'ozone et/ou d'eau.

Selon un mode particulier de réalisation, l'oxydation de la partie superficielle du substrat 1 peut être réalisée à partir d'oxygène et de rayonnements ultraviolets ayant une gamme de longueurs d'onde comprise entre 160nm et 400nm. Les longueurs d'onde des rayonnements ultraviolets utilisés sont, par exemple, d'environ 185nm et d'environ 254nm. Dans ce mode particulier de réalisation, l'oxygène, sous l'action des rayonnements ultraviolets, se dissocie en radicaux libres O˙ et en ozone. Les radicaux libres peuvent oxyder la surface du silicium.

De plus, la température pendant l'opération d'oxydation peut être comprise entre la température ambiante et environ 900°C, tandis que la pression peut être comprise entre environ 10⁻⁴ et environ 10⁵ Pa. Cependant, de manière avantageuse, la température et la pression sont respectivement la température ambiante et la pression ambiante.

Une fois le film mince 11 formé, le procédé de réalisation d'au moins une cellule photovoltaïque se poursuit par le dépôt successif de couches minces. En particulier, dans le mode de réalisation représenté sur la figure 3, la formation du film mince 11 est directement suivie des dépôts successifs suivants :
- dépôt de la couche mince 2 en silicium amorphe intrinsèque,
- dépôt de la couche mince 3 en silicium amorphe dopé p sur ledit film mince 11,
- dépôt de l'électrode 4 sur la couche mince 3,
- dépôt du collecteur de courant 5 sur l'électrode 4
- et dépôt de l'électrode 6 sur la face arrière 1 b du substrat 1.

Comme mentionné ci-dessus, une étape intermédiaire pour retirer l'oxyde de silicium amorphe, éventuellement formé sur le film mince 11 lors de l'opération d'oxydation radicalaire, peut être réalisée avant le dépôt successif desdites couches minces.

Ainsi, il a été constaté que la présence d'un film mince en oxyde cristallin de silicium sur une des faces du substrat 1 et, en particulier lorsqu'il est réalisé par une oxydation radicalaire, permet d'obtenir des caractéristiques de passivation importantes, l'oxyde cristallin de silicium présentant une très bonne qualité intrinsèque. Ainsi, un tel film mince en oxyde cristallin de silicium permet d'empêcher les porteurs de charge d'être piégés en se recombinant. Il joue donc le rôle d'un oxyde tunnel en assurant une passivation de surface du substrat 1. Ainsi, il est possible d'augmenter la tension de circuit ouvert de la cellule photovoltaïque et potentiellement d'augmenter le courant de court-circuit et de faire varier le facteur de forme de la cellule sans dégrader le rendement.

De plus, cela permet de faciliter le procédé de réalisation d'une ou plusieurs cellules photovoltaïques. En effet, la surface du substrat 1 ainsi recouverte d'un film mince en oxyde est stable pendant une durée plus longue, ce qui permet d'augmenter le temps d'attente possible, avant de réaliser les étapes suivantes du procédé de réalisation (de dépôt des autres couches minces). De plus, dans certains cas et selon les conditions de nettoyage, il n'est pas nécessaire d'enlever l'oxyde natif présent à la surface du substrat 1, avant de former le film mince en oxyde cristallin de silicium. Celui-ci peut, sous certaines conditions, être transformé sous forme cristalline pendant l'étape d'oxydation radicalaire. Enfin, le fait de réaliser au moins un film mince en oxyde cristallin de silicium comme couche de passivation permet de s'affranchir d'une étape de nettoyage du substrat avec de l'acide fluorhydrique avant de déposer du silicium amorphe intrinsèque, ce qui permet d'améliorer la sécurité du procédé.

Sur la figure 3, la face arrière 1 b du substrat 1 est plane et elle est recouverte, comme dans le mode de réalisation selon la figure 1, d'une électrode 6. Par contre, comme illustré sur la figure 4, la face arrière 1 b peut être texturée et recouverte d'un empilement multicouche comme représenté sur la figure 2, c'est-à-dire uniformément et successivement par :
- une couche en silicium amorphe intrinsèque 7,
- une couche en silicium amorphe 8, très fortement dopée, par exemple, de type n,
- une électrode 9, en ITO par exemple
- et un collecteur de courant 10 sous la forme d'un peigne.

Par ailleurs, un film mince additionnel 12 peut être disposé, dans certains modes de réalisation, sur la face arrière 1 b du substrat 1.

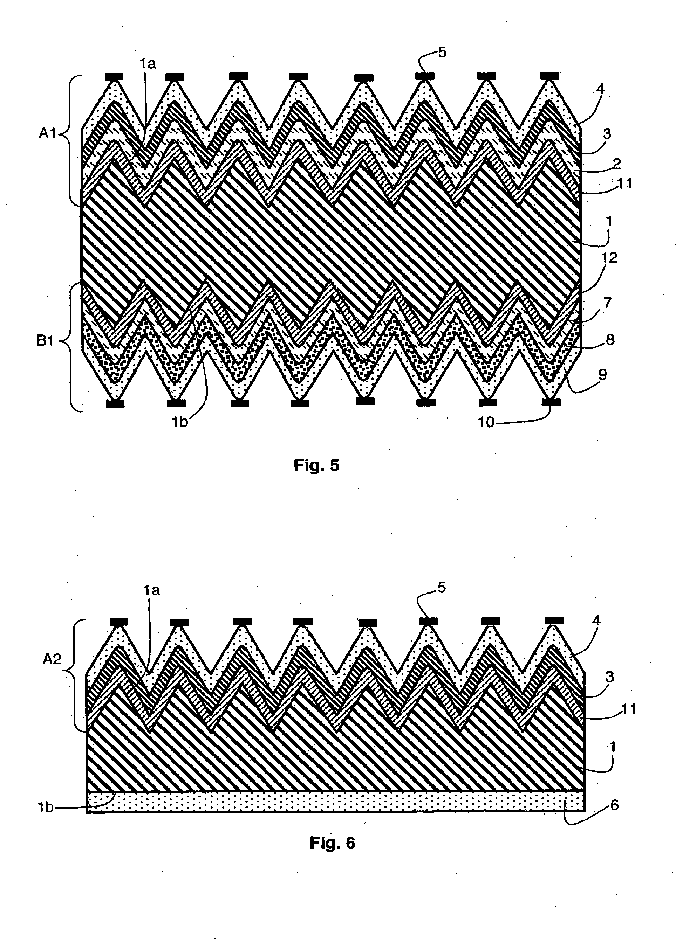

Ainsi, selon une variante de réalisation et comme représenté sur la figure 5, la cellule peut comporter une face avant 1a recouverte par le même empilement multicouche A1 que celui représenté sur les figures 3 et 4. Par contre, la face arrière 1 b du substrat 1 est, comme la face avant 1a, texturée et elle est, de plus, recouverte d'un film mince 12 additionnel en oxyde cristallin de silicium. Ledit film mince 12 additionnel est recouvert par un empilement multicouche formé d'une couche mince amorphe intrinsèque 7, d'une couche mince en silicium amorphe 8 dopé n, d'une électrode 9 et d'un collecteur de courant 10, l'ensemble formant, alors, un empilement multicouche recouvrant la face arrière 1b du substrat 1 et noté B1 sur la figure 5.

Dans certains cas, la très bonne qualité intrinsèque de l'oxyde cristallin de silicium est suffisante pour obtenir une bonne passivation de surface et peut rendre la présence d'une couche mince de passivation en silicium amorphe intrinsèque 2 entre ledit film et la couche mince en silicium amorphe dopé inutile.

Alors, le film mince 11 peut être directement disposé entre le substrat 1 et la couche en silicium amorphe dopé p 3. Ainsi, dans ces modes de réalisation, il peut être envisagé de remplacer l'empilement multicouche A1 par un empilement multicouche A2 se distinguant de l'empilement A1 par la suppression de la couche mince en silicium intrinsèque 2 entre le film mince 11 et la couche mince en silicium amorphe 3 dopé p. Un tel empilement A2 pourrait alors être associé à des modes de réalisation diverses pour la face arrière 1b du substrat 1 comme illustré sur les figures 6 à 9.

Ainsi, ledit empilement A2 recouvrant la face avant 1a du substrat 1 est associé, sur la figure 6, à une électrode 6 recouvrant la face arrière 1 b plane du substrat 1.

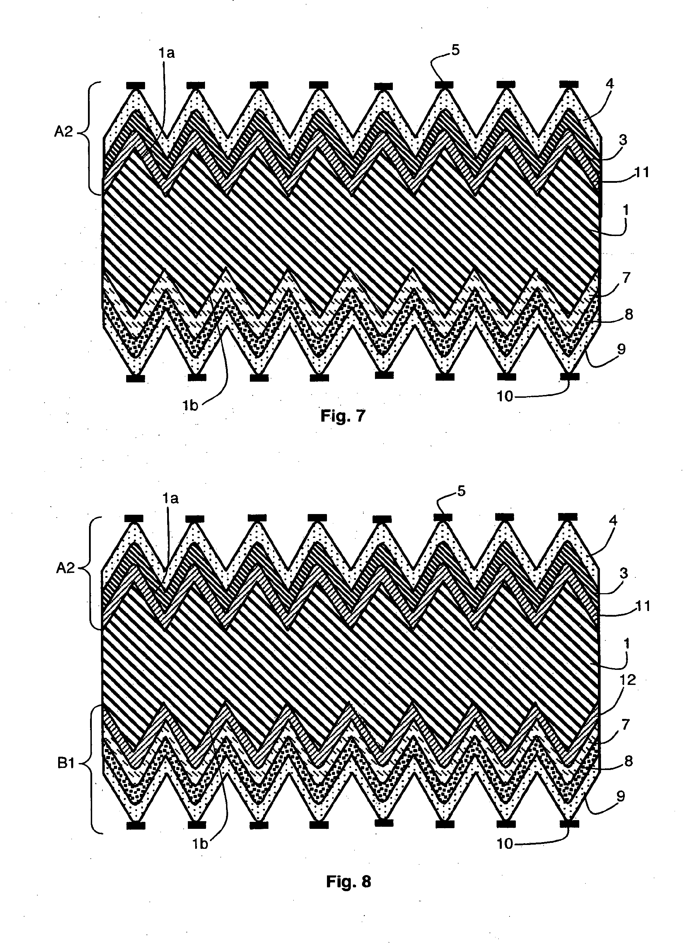

Sur la figure 7, la face arrière 1b est texturée comme la face avant 1a du substrat 1 et elle est recouverte par un empilement multicouche tel que celui représenté sur la figure 2, c'est-à-dire un empilement multicouche ne comprenant pas de film mince additionnel 12 en oxyde cristallin de silicium.

Sur la figure 8, la face arrière 1 b du substrat 1 est aussi texturée comme la face avant 1b du substrat et elle est recouverte d'un empilement multicouche B1, c'est-à-dire un empilement comprenant un film mince additionnel 12 intercalé entre le substrat 1 et la couche mince en silicium amorphe 8 dopée de type n.

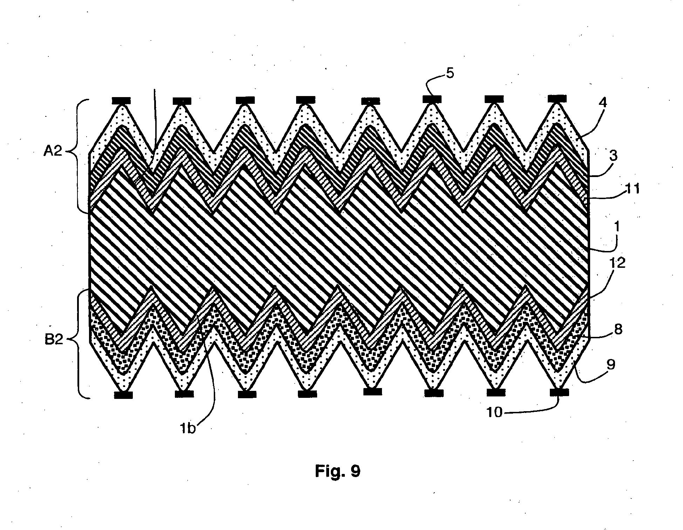

Enfin, sur la figure 9, la face arrière 1b du substrat 1 est aussi texturée comme la face avant 1 b du substrat et elle est recouverte d'un empilement multicouche B2. L'empilement multicouche B2 diffère de l'empilement B1 en ce qu'il ne comprend pas de couche en silicium amorphe intrinsèque 7 disposée entre le film mince additionnel 12 et la couche en silicium amorphe 8.

Lorsque la cellule photovoltaïque comporte un film mince 11 disposé sur la face avant 1a du substrat 1 ainsi qu'un film mince additionnel 12 disposé sur la face arrière 1b du substrat 1, les deux films minces 11 et 12 peuvent être réalisés soit de manière simultanée, soit de manière successive.

Dans le cas d'une réalisation successive des deux films minces 11 et 12, la cellule photovoltaïque peut, avantageusement, être réalisée de la manière suivante :
- le film mince 11, la couche mince en silicium amorphe intrinsèque 2 éventuelle et la couche en silicium amorphe 3 dopé de type p pour former l'hétérojonction sont successivement formés sur la face avant 1a du substrat 1,
- puis, le film mince additionnel 12, la couche mince en silicium amorphe intrinsèque 7 éventuelle et la couche en silicium amorphe 8 dopé de type n sont successivement formés sur la face arrière 1 b du substrat 1
- et, enfin, les électrodes 4 et 9 ainsi que les collecteurs de courant 5 et 10 respectivement associés auxdites électrodes 4 et 9 sont formés sur leur empilement respectif.

Les deux films minces 11 et 12 sont, avantageusement, chacun réalisés par oxydation radicalaire, au moyen de radicaux libres tels que des radicaux oxygénés et éventuellement assisté par traitement plasma ou des rayonnements ultraviolets.

Selon une autre variante de réalisation, la cellule photovoltaïque peut aussi comporter un seul film mince en oxyde cristallin de silicium, disposé non pas sur la face avant 1a du substrat 1 (cas des figures 3, 4, 6 et 7), mais sur la face arrière 1b du substrat 1. Le film mince en oxyde cristallin de silicium est, toujours avantageusement, réalisé par oxydation radicalaire, au moyen de radicaux oxygénés et éventuellement assisté par traitement plasma ou des rayonnements ultraviolets. Dans ce cas, la face avant 1 a est, avantageusement, recouverte par une couche mince en silicium amorphe intrinsèque 2 disposée entre le substrat 1 et la couche mince en silicium amorphe 3 dopé p. La face arrière 1 b peut (ou non) comporter une couche mince en silicium amorphe intrinsèque 7 entre le film mince eh oxyde cristallin de silicium et la couche en silicium amorphe dopé 8.

L'invention n'est pas limitée aux modes de réalisation décrits ci-dessus, en particulier en ce qui concerne le type de dopage (n ou p) du substrat 1 et des couches en silicium amorphe dopé 3 et 8.

Par conséquent, l'invention n'est pas limitée aux modes de réalisation comprenant un substrat en silicium cristallin dopé n et des couches en silicium amorphe 3 et 8, respectivement dopées p et n. La couche en silicium amorphe 3 doit présenter un type de dopage (p ou n) opposé au type de dopage (n ou p) du substrat 1, afin de former l'hétérojonction et la couche en silicium amorphe 8 disposée du côté de la face arrière 1 b du substrat 1 doit présenter un même type de dopage (n ou p) que celui du substrat 1 (n ou p).

Par ailleurs, au lieu d'être en silicium amorphe, les couches minces 3 et 8 peuvent aussi être en silicium micro-cristallin.

Enfin, au lieu d'utiliser du silicium amorphe intrinsèque pour les couches 2 et 7, il est possible d'utiliser du silicium amorphe faiblement dopé également appelé microdopé, le dopage étant du même type que celui de la couche en silicium amorphe 3 ou 8 destinée à être disposée sur ladite couche 2 ou 7. Par silicium amorphe faiblement dopé ou microdopé, on entend un dopage sensiblement inférieur aux niveaux de dopage couramment utilisés. Ainsi, à titre d'exemple, la concentration de dopants de chacune des couches en silicium amorphe 2 et 7 peut être comprise entre 1.10¹⁶ et 1.10¹⁸ at/cm³, tandis que les couches minces en silicium amorphe 3 et 8 peuvent chacune avoir une concentration de dopants comprise entre 1.10¹⁹ at.cm³ et 1.10²² at.cm³.

Le fait de remplacer le silicium amorphe intrinsèque par du silicium amorphe microdopé permet, par le faible niveau de dopage, d'obtenir une faible densité d'états localisés et donc un faible taux de recombinaison des porteurs à l'interface avec le substrat ainsi qu'une tension de circuit ouvert élevée. De plus, la couche amorphe microdopée présente une conductivité sensiblement plus élevée qu'une couche amorphe intrinsèque, ce qui réduite la résistance série de la cellule et améliore sensiblement son facteur de forme.

## Revendications

1. Cellule photovoltaïque à hétérojonction comprenant un substrat (1) en silicium cristallin présentant un type de dopage donné et une couche en silicium amorphe ou micro-cristallin (3, 8), **caractérisée en ce qu'**elle comporte au moins un film mince en oxyde cristallin de silicium (11), disposé directement sur une face (1a, 1b) du substrat (1), entre ledit substrat (1) et ladite couche en silicium amorphe ou micro-cristallin (3, 8).

2. Cellule selon l'une la revendication 1, **caractérisée en ce que** le film mince en oxyde cristallin de silicium (11) est constitué par une partie superficielle du substrat (1) oxydée par des radicaux.

3. Cellule selon l'une des revendications 1 et 2, **caractérisé en ce que** le film mince en oxyde cristallin de silicium (11) a une épaisseur inférieure ou égale à 2 nanomètres.

4. Cellule selon l'une quelconque des revendications 1 à 3, **caractérisée en ce qu'**une couche mince en silicium amorphe intrinsèque ou microdopée (2, 7) est interposée entre le film mince en oxyde cristallin de silicium (11) et la couche en silicium amorphe ou micro-cristallin (3, 8).

5. Cellule selon l'une quelconque des revendications 1 à 3, **caractérisée en ce que** le film mince en oxyde cristallin de silicium (11) est directement en contact avec la couche en silicium amorphe ou micro-cristallin (3, 8).

6. Cellule selon l'une quelconque des revendications 1 à 5, **caractérisée en ce que** la couche en silicium amorphe ou micro-cristallin (8) présente un type de dopage identique à celui du substrat (1) en silicium cristallin.

7. Cellule selon l'une quelconque des revendications 1 à 5, **caractérisée en ce que** la couche en silicium amorphe ou micro-cristallin (3) présente un type de dopage opposé à celui du substrat (1) en silicium cristallin.

8. Cellule selon la revendication 7, **caractérisée en ce qu'**elle comporte un film mince en oxyde cristallin de silicium additionnel (12), disposé directement sur une autre face (1b) du substrat (1), entre ledit substrat (1) et une couche en silicium amorphe ou micro-cristallin additionnelle (8), ladite couche en silicium amorphe ou micro-cristallin additionnelle (8) présentant un type de dopage identique à celui du substrat (1) en silicium cristallin.

9. Cellule selon la revendication 8, **caractérisée en ce qu'**une couche mince en silicium amorphe intrinsèque ou microdopée additionnelle (7) est interposée entre le film mince en oxyde cristallin de silicium additionnel (12) et la couche en silicium amorphe ou micro-cristallin additionnelle (8).

10. Cellule selon la revendication 8, **caractérisée en ce que** le film mince en oxyde cristallin de silicium additionnel (12) est directement en contact avec la couche en silicium amorphe ou micro-cristallin additionnelle (8).

11. Cellule selon l'une quelconque des revendications 1 à 10, **caractérisée en ce qu'**au moins une face (1a, 1 b) du substrat (1) en silicium cristallin est texturée.

12. Cellule selon l'une quelconque des revendications 1 à 11, **caractérisée en ce qu'**une couche en oxyde amorphe de silicium est disposée directement sur le film mince en oxyde cristallin de silicium (11, 12), entre ledit film mince et la couche en silicium amorphe ou micro-cristallin (3, 8).

13. Procédé de réalisation d'au moins une cellule photovoltaïque selon l'une quelconque des revendications 1 à 12, **caractérisé en ce que** le film mince en oxyde cristallin de silicium (11, 12) est réalisé, avant la formation de la couche en silicium amorphe ou micro-cristallin (3, 8), par une oxydation superficielle radicalaire d'une surface du substrat (1).

14. Procédé selon la revendication 13, **caractérisé en ce que** l'oxydation superficielle radicalaire est réalisée au moyen de radicaux oxygénés obtenus à partir d'oxygène et/ou d'ozone et/ou d'eau.

15. Procédé selon la revendication 14, **caractérisé en ce que** l'oxydation superficielle d'une surface du substrat (1) est assistée par application de rayonnements ultraviolets sur ladite surface.

16. Procédé selon la revendication 15, **caractérisé en ce que** les radicaux oxygénés étant obtenus au moins à partir d'oxygène, les rayonnements ultraviolets ont une gamme de longueurs d'onde comprise entre 160 nm et 400 nm.

17. Procédé selon l'une des revendications 13 et 14, **caractérisé en ce que** l'oxydation superficielle d'une surface du substrat (1) est assistée par plasma.

18. Procédé selon l'une quelconque des revendications 13 à 17, **caractérisé en ce que** l'oxydation superficielle radicalaire d'une surface du substrat (1) est suivie d'une étape de décapage pour retirer une partie d'oxyde de silicium formée pendant l'oxydation superficielle radicalaire, sous forme amorphe, sur la surface du film mince (11, 12).

## Patentansprüche

1. Photovoltaikzelle mit Heteroübergang, umfassend ein Substrat (1) aus kristallinem Silizium, das einen gegebenen Dotierungstyp aufweist, und eine Schicht aus amorphem oder mikrokristallinem Silizium (3, 8), **dadurch gekennzeichnet, dass** sie wenigstens einen dünnen Film aus kristallinem Siliziumoxid (11), der direkt auf einer Seite (1a, 1b) des Substrats (1), zwischen dem Substrat (1) und der Schicht aus amorphem oder mikrokristallinem Silizium (3, 8) angeordnet ist, umfasst.

2. Zelle nach Anspruch 1, **dadurch gekennzeichnet, dass** der dünne Film aus kristallinem Siliziumoxid (11) durch einen durch Radikale oxidierten oberflächlichen Teil des Substrats (1) gebildet ist.

3. Zelle nach einem der Ansprüche 1 und 2, **dadurch gekennzeichnet, dass** der dünne Film aus kristallinem Siliziumoxid (11) eine Dicke von weniger als oder gleich 2 Nanometern aufweist.

4. Zelle nach einem der Ansprüche 1 bis 3, **dadurch gekennzeichnet, dass** eine dünne Schicht aus intrinsischem oder mikrodotiertem amorphem Silizium (2, 7) zwischen dem dünnen Film aus kristallinem Siliziumoxid (11) und der Schicht aus amorphem oder mikrokristallinem Silizium (3, 8) eingefügt ist

5. Zelle nach einem der Ansprüche 1 bis 3, **dadurch gekennzeichnet, dass** der dünne Film aus kristallinem Siliziumoxid (11) direkt in Kontakt mit der Schicht aus amorphem oder mikrokristallinem Silizium (3, 8) ist.

6. Zelle nach einem der Ansprüche 1 bis 5, **dadurch gekennzeichnet, dass** die Schicht aus amorphem oder mikrokristallinem Silizium (8) einen Dotierungstyp aufweist, der mit demjenigen des Substrats (1) aus kristallinem Silizium identisch ist.

7. Zelle nach einem der Ansprüche 1 bis 5, **dadurch gekennzeichnet, dass** die Schicht aus amorphem oder mikrokristallinem Silizium (3) einen Dotierungstyp aufweist, der zu demjenigen des Substrats (1) aus kristallinem Silizium entgegengesetzt ist.

8. Zelle nach Anspruch 7, **dadurch gekennzeichnet, dass** sie einen zusätzlichen dünnen Film aus kristallinem Siliziumoxid (12) umfasst, der direkt auf einer anderen Seite (1b) des Substrats (1), zwischen dem Substrat (1) und einer zusätzlichen Schicht aus amorphem oder mikrokristallinem Silizium (8) angeordnet ist, wobei die zusätzliche Schicht aus amorphem oder mikrokristallinem Silizium (8) einen Dotierungstyp aufweist, der mit demjenigen des Substrats (1) aus kristallinem Silizium identisch ist.

9. Zelle nach Anspruch 8, **dadurch gekennzeichnet, dass** eine zusätzliche dünne Schicht aus intrinsischem oder mikrodotiertem amorphem Silizium (7) zwischen dem zusätzlichen dünnen Film aus kristallinem Siliziumoxid (12) und der zusätzlichen Schicht aus amorphem oder mikrokristallinem Silizium (8) eingefügt ist.

10. Zelle nach Anspruch 8, **dadurch gekennzeichnet, dass** der zusätzliche dünne Film aus kristallinem Siliziumoxid (12) direkt in Kontakt mit der zusätzlichen Schicht aus amorphem oder mikrokristallinem Silizium (8) ist.

11. Zelle nach einem der Ansprüche 1 bis 10, **dadurch gekennzeichnet, dass** wenigstens eine Seite (1a, 1b) des Substrats (1) aus kristallinem Silizium texturiert ist.

12. Zelle nach einem der Ansprüche 1 bis 11, **dadurch gekennzeichnet, dass** eine Schicht aus amorphem Siliziumoxid direkt auf dem dünnen Film aus kristallinem Siliziumoxid (11, 12), zwischen dem dünnen Film und der Schicht aus amorphem oder mikrokristallinem Silizium (3, 8) angeordnet ist.

13. Verfahren zur Herstellung wenigstens einer Photovoltaikzelle nach einem der Ansprüche 1 bis 12, **dadurch gekennzeichnet, dass** der dünne Film aus kristallinem Siliziumoxid (11, 12) vor der Bildung der Schicht aus amorphem oder mikrokristallinem Silizium (3, 8) durch eine oberflächliche radikalische Oxidation einer Oberfläche des Substrats (1) ausgebildet wird.

14. Verfahren nach Anspruch 13, **dadurch gekennzeichnet, dass** die oberflächliche radikalische Oxidation mit Hilfe von aus Sauerstoff und/oder Ozon und/oder Wasser gewonnenen Sauerstoffradikalen vollzogen wird.

15. Verfahren nach Anspruch 14, **dadurch gekennzeichnet, dass** die oberflächliche Oxidation einer Oberfläche des Substrats (1) durch Anwendung von UV-Strahlen auf die Oberfläche unterstützt wird.

16. Verfahren nach Anspruch 15, **dadurch gekennzeichnet, dass** wenn die Sauerstoffradikale wenigstens aus Sauerstoff gewonnen werden, die UV-Strahlen einen Wellenlängenbereich zwischen 160 nm und 400 nm haben.

17. Verfahren nach einem der Ansprüche 13 und 14, **dadurch gekennzeichnet, dass** die oberflächliche Oxidation einer Oberfläche des Substrats (1) durch Plasma unterstützt wird.

18. Verfahren nach einem der Ansprüche 13 bis 17, **dadurch gekennzeichnet dass** sich an die oberflächliche radikalische Oxidation einer Oberfläche des Substrats (1) ein Beizschritt anschließt, um einen Siliziumoxidteil, der während der oberflächlichen radikalischen Oxidation in amorpher Form auf der Oberfläche des dünnen Films (11, 12) gebildet wird, zu entfernen.

## Claims

1. Photovoltaic heterojunction cell including a substrate (1) of crystalline silicon with a given doping type and a layer (3, 8) of amorphous or microcrystalline silicon, **characterized in that** it comprises at least one thin film (11) of crystalline silicon oxide, arranged directly on a face (1a, 1b) of the substrate (1), between said substrate (1) and said layer (3, 8) of amorphous or microcrystalline silicon.

2. Cell according to claim 1, **characterized in that** the thin film (11) of crystalline silicon oxide is composed of a surface part of the substrate (1), which is oxidized by radicals.

3. Cell according to any one of the claims 1 and 2, **characterized in that** the thin film (11) of crystalline silicon oxide has a thickness lower than or equal to 2 nanometers.

4. Cell according to any one of the claims 1 to 3, **characterized in that** a thin layer (2, 7) of intrinsic or microdoped amorphous silicon is interposed between the thin film (11) of crystalline silicon oxide and the layer (3, 8) of amorphous or microcrystalline silicon.

5. Cell according to any one of the claims 1 to 3, **characterized in that** the thin film (11) of crystalline silicon oxide is directly in contact with the layer (3, 8) of amorphous or microcrystalline silicon.

6. Cell according to any one of the claims 1 to 5, **characterized in that** the layer (8) of amorphous or microcrystalline silicon has a doping type identical to that of the substrate (1) of crystalline silicon.

7. Cell according to any one of the claims 1 to 5, **characterized in that** the layer (3) of amorphous or microcrystalline silicon has a doping type opposite that of the substrate (1) of crystalline silicon.

8. Cell according to claim 7, **characterized in that** it comprises a additional thin film (12) of crystalline silicon oxide, arranged directly on another face (1b) of the substrate (1), between said substrate (1) and a additional layer (8) of amorphous or microcrystalline silicon, said additional layer (8) of amorphous or microcrystalline silicon having a doping type identical to that of the substrate (1) of crystalline silicon.

9. Cell according to claim 8, **characterized in that** an additional thin layer (7) of intrinsic or microdoped amorphous silicon is interposed between the additional thin film (12) of crystalline silicon oxide and the additional layer (8) of amorphous or microcrystalline silicon.

10. Cell according to claim 8, **characterized in that** the additional thin film (12) of crystalline silicon oxide is directly in contact with the additional layer (8) of amorphous or microcrystalline silicon.

11. Cell according to any one of the claims 1 to 10, **characterized in that** at feast one face (1 a, 1 b) of the substrate (1) of crystalline silicon is textured.

12. Cell according to any one of the claims 1 to 11, **characterized in that** a layer of amorphous silicon oxide is arranged directly on the thin film (11, 12) of crystalline oxide silicon, between said thin film and the layer (3, 8) of amorphous or microcrystalline silicon.

13. Method for manufacturing at least one photovoltaic cell according to any one of the claims 1 to 12, **characterized in that** the thin film (11, 12) crystalline silicon oxide is made, before the formation of the layer (3, 8) of amorphous or microcrystalline silicon, by a radical-like surface oxidation of a surface of the substrate (1).

14. Method according to claim 13, **characterized in that** the radical-like surface oxidation is carried out by means of oxygenated radicals obtained from oxygen and/or ozone and/or water.

15. Method according to claim 14, **characterized in that** the surface oxidation of a surface of the substrate (1) is assisted by applying ultraviolet radiations to said surface.

16. Method according to claim 15, **characterized in that** as the oxygenated radicals are obtained at least from oxygen, the ultraviolet radiations have wavelengths ranging between 160 nm and 400 nm.

17. Method according to any one of the claims 13 and 14, **characterized in that** the surface oxidation of a surface of the substrate (1) is assisted by plasma.

18. Method according to any one of the claims 13 to 17, **characterized in that** the radical-like surface oxidation of a surface of the substrate (1) is followed by a stripping step for withdrawing a part of silicon oxide formed during radical-like surface oxidation, in an amorphous form, on the surface of the thin film (11, 12).
